# EUROPEAN PATENT SPECIFICATION

(11) **EP 3 418 423 B1**
(45) Date of publication and mention of the grant of the patent: **11.09.2024**
(21) Application number: 18179275.5
(22) Date of filing: 22.06.2018
(51) Int. Cl.: C23C 16/12, C23C 16/455, C23C 10/28, C23C 10/60, B22F 10/28, B22F 10/62, C23F 1/20, C23F 1/44, C23F 4/00

(54) **METHOD FOR SMOOTHING SURFACE ROUGHNESS OF COMPONENTS**
VERFAHREN ZUM GLÄTTEN DER OBERFLÄCHENRAUHEIT VON BAUTEILEN
PROCÉDÉ DE LISSAGE DE RUGOSITÉ DE SURFACE DE COMPOSANTS

(30) Priority: 23.06.2017 US 201715631803
(43) Date of publication of application: 26.12.2018
(73) Proprietor: Hamilton Sundstrand Corporation, Charlotte, NC 28217-4578 (US)
(72) Inventor: JAWOROWSKI, Mark R., Glastonbury, CT Connecticut 06033 (US); BIANCO, Robert, Columbia Station, CT Connecticut 44028 (US); MIRONETS, Sergey, Charlotte, NC North Carolina 28202 (US); Lomasney, Gary M., Glastonbury, CT Connecticut 06033 (US)
(74) Representative: Dehns

(56) References cited:
- EP-A1- 2 570 595
- EP-A1- 3 135 794
- EP-A1- 3 165 305
- US-A- 5 573 862

## Description

### BACKGROUND

This disclosure relates to a method of reducing the surface roughness.

Additively manufactured components often include excessive surface roughness from satellite particles or surface asperities that occurring from incomplete consolidation at the component surface. Satellite particles can detach and cause damage to other surrounding components. Smoothing of such roughnesses can be difficult, especially in internal passages, blind holes, or other non-line-of-sight surfaces.

Methods of smoothing surfaces are known from EP 2 570 595, EP 3 135 794 and EP 3 165 305.

### SUMMARY

A method for reducing surface roughness of a component is provided as defined by claims 1-9.

### BRIEF DESCRIPTION OF THE DRAWINGS

Figure 1 schematically shows a component with rough areas.
Figure 2 schematically shows a method of smoothing the component.
Figure 3 schematically shows a surface of the component with a reactive layer.

### DETAILED DESCRIPTION

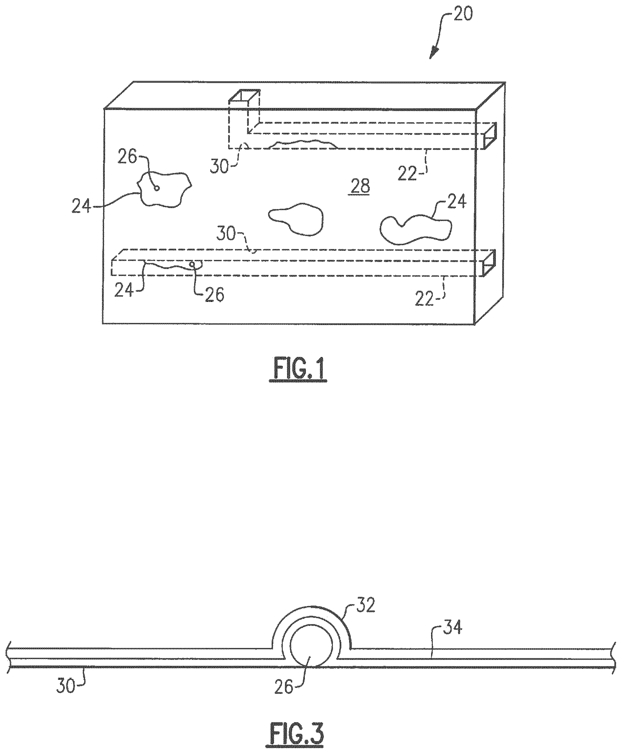

Figure 1 is a schematic view of an example component 20 with internal features 22. As an example, the component 20 is a heat exchanger and the internal features 22 are cooling passages, lattice structures, blind holes, or the like. However, the component 20 can alternatively be any type of gas turbine engine component, such a fuel nozzle, airfoil, combustor liner, another hollow part, or even a non-engine component.

The component 20 is formed by an additive manufacturing process, such as a powder-bed fusion process. This process creates rough areas or surfaces 24. For instance, the additive manufacturing process results in partially melted and solidified powder at the interface of a powder bed and a laser beam during the power-bed fusion process. This partially melted and solidified powder forms rough surfaces or areas 24. In another example, rough surfaces or areas 24 include partially sintered areas. This disclosure is not limited to components produced by additive manufacturing and other processes that produce rough surfaces may also benefit. The rough areas 24 can be on an outer surface 28 of the component 20 or on non-line-of-sight surfaces 30 of the internal features 22, which are particularly challenging to access. In one example, some of the rough areas 24 include particles 26 that are partially attached to the component 20, known as "satellite particles." In one example, the satellite attached particles 26 are partially melted particles or partially sintered particles left behind during additive manufacturing of component 20, as discussed above.

In the case where the component 20 is a heat exchanger and internal features 22 are cooling passages, satellite particles 26 can be liberated from the heat exchanger 20 during operation and can damage other parts of the heat exchanger 20 and/or other adjacent components. Also, rough areas 24 within cooling passages 22 cause excessive pressure drop of fluid flowing through the cooling passages 22, which reduces the cooling efficiency of the heat exchanger 20 and reduces the fatigue life of the heat exchanger 20.

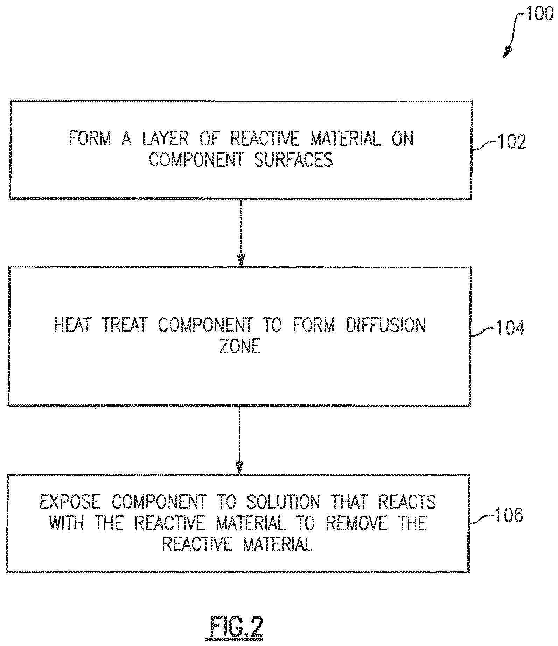

Figure 2 shows a method 100 of smoothing the rough areas 24 of the component 20. In step 102, a layer 32 of reactive material is formed on the rough areas 24 of the component 20. Figure 3 shows a layer 32 of reactive material on a non-line-of-sight surface 30 with a satellite particle 26. The reactive material is more reactive than the material of the component 20. That is, a reaction can be induced with the reactive material but not with the material of the component 20, it least to a substantially lesser extent. This enables the reactive material to be removed without disturbing or affecting the material of the component 20, as will be discussed further below. In one example, the dissolution rate of the reactive material is at least ten times greater than the dissolution rate of the material of the component 20. In a further example, the dissolution rate of the reactive material is 100 times greater than the dissolution rate of the material of the component 20.

For example, the component 20 discussed herein is a nickel alloy, which is relatively inert, and the reactive material is aluminum. However, it should be understood that other component 20 materials and reactive materials can be used. For instance, the reactive material can include any of aluminum, bromine, silicon, chromium, zinc, tin, titanium, yttrium, any combination thereof, or another reactive element.

The aluminum is applied to the component 20 by a gas phase deposition process, such as Chemical Vapor Deposition ("CVD"), to form the reactive layer 32. In a particular example, the aluminum is applied by chlorine-catalyzed CVD of aluminum vapor. Gas phase deposition processes typically involve flowing gas with a material to be deposited (in this example, aluminum) into a chamber containing the component 20. The gas flow is laminar. For instance, the Reynolds number is less than about 2300. Laminar flow allows for more concentrated deposition of aluminum on high points (such as rough areas 24 and satellite particles 26) of the surfaces 28, 30 of the component 20. This in turn ensures the satellite particles 26 are substantially covered by the reactive material.

Referring again to Figure 2, in step 104, the component 20 with the reactive layer 32 is heat treated. Heat treatment can be performed by any known method, and the parameters of the heat treatment will depend on the material of the component 20 and the reactive layer 32. The heat treatment causes diffusion of the component 20 material and the reactive layer 32 material into a diffusion zone 34 (Figure 3). In the present example, the diffusion zone 34 contains a mixture of nickel and aluminum. Importantly, the reactive layer 32 and diffusion zone 34 are present over the satellite particles 26.

In step 106, component 20 is exposed to a solution that reacts with the reactive material in the reactive layer 32 and the diffusion zone 34 to remove the reactive layer 32 and the diffusion zone 34. In one example, the solution is an acidic solution, such as a nitric acid solution. More particularly, the solution is a 20%-50% nitric acid solution. The solution reacts with the aluminum whereby aluminum-rich areas of the component 20 are dissolved away, including the diffusion zone 34 and the reactive layer 32.

As discussed above, the satellite particles 26 are only partially attached to the surfaces 28, 30 of the component 20. In this dissolving process, the satellite particles 26 are substantially covered by the reactive layer 32 and diffusion zone 34. As the reactive layer 32 and diffusion zone 34 are dissolved away, the satellite particles 26 break free from the surface 28, 30 of the component to expose a new smoother surface. The freed particles 26 are carried away by the solution. This is especially effective as good coverage of the satellite particles 26 is achieved by laminar flow CVD, as discussed above. This results in smoothing of rough areas 24. Exposure to the solution can include flowing the solution through the internal features 22 of the component 20. This allows the dissolving process and satellite particle removal 26 to occur on non-line-of-sight surfaces 30. The removal step does not affect the underlying nickel alloy of the component 20 because the nickel alloy is inert with respect to the solution, or at least substantially less reactive than the aluminum.

In one example, during step 106, the component 20 is exposed to the solution at an elevated temperature. More particularly, the exposure occurs at about 32.2 - 37.8 ° C (90 - 100°F).

The method discussed above results in smoothing of outer surfaces 28 and non-line-of-sight surfaces 30 of the component 20 without damaging or altering the material of the component 20, which improves the service life as well as tensile and fatigue properties of the component 20. Furthermore, the method can be used to smooth non-line-of-sight surfaces 30, which are difficult to smooth by other methods (such as electrochemical methods or employing abrasive media), particularly where the internal features 22 have complex or convoluted shapes. This in turn results in time and costs savings for manufacturing components with internal features.

Furthermore, the foregoing description shall be interpreted as illustrative and not in any limiting sense. A worker of ordinary skill in the art would understand that certain modifications could come within the scope of this invention as defined by the claims. For these reasons, the following claims should be studied to determine the true scope of this invention.

## Claims

1. A method for reducing surface roughness of a component, comprising:
forming a layer (32) of reactive material on a surface (28) of a component (20), the surface of the component having at least one partially attached particle (26), whereby the reactive material substantially covers the at least one partially attached particle; and
dissolving the reactive material, wherein dissolving the reactive material covering the partially attached particles causes the partially attached particles to break free from the surface of the component, leaving a new smooth surface; and **characterized by**
further comprising forming the component by additive manufacturing, and wherein the at least one partially attached particle is one of a partially melted particle and a partially sintered particle; and
wherein forming the layer of reactive material is accomplished by a gas phase deposition process, and wherein the gas phase deposition process includes flowing gas containing the reactive material in a laminar flow.

2. The method of claim 1, wherein the component includes an internal feature, and the internal feature includes a non-line-of-sight surface (30).

3. The method of claim 2, wherein the at least one partially attached particle is on the non-line-of-sight surface.

4. The method of claim 3, further comprising conveying a solution through the internal features during the dissolving step, the solution dissolving the reactive material.

5. The method of claim 4, wherein the solution is inert with respect to the component.

6. The method of any preceding claim, wherein the reactive material is an element selected from one of aluminum, bromine, silicon, chromium, zinc, tin, titanium, yttrium, or any combination thereof, and preferably wherein the reactive material is aluminum and the component comprises a nickel alloy.

7. The method of any preceding claim, further comprising heat treating the component to cause diffusion of the reactive material into a diffusion zone.

8. The method of claim 7, wherein the dissolving step dissolves away the layer of reactive material and the diffusion zone.

9. The method of any preceding claim, wherein the dissolving step is accomplished with an acidic solution, and preferably wherein the acidic solution is a 20% - 50% solution of nitric acid, and wherein the dissolving step is performed at a temperature of between about 32.2 and 37.8 °C (90 and 100°F).

## Patentansprüche

1. Verfahren zum Reduzieren der Oberflächenrauheit eines Bauteils, umfassend:
Bilden einer Schicht (32) aus reaktivem Material auf einer Oberfläche (28) eines Bauteils (20), wobei die Oberfläche des Bauteils mindestens ein teilweise angebrachtes Partikel (26) aufweist, wodurch das reaktive Material im Wesentlichen das mindestens eine teilweise angebrachte Partikel bedeckt; und Auflösen des reaktiven Materials, wobei das Auflösen des reaktiven Materials, das die teilweise angebrachten Partikel bedeckt, bewirkt, dass sich die teilweise angebrachten Partikel von der Oberfläche des Bauteils lösen und eine neue glatte Oberfläche hinterlassen; und **gekennzeichnet durch** ferner Umfassen des Bildens des Bauteils durch additive Fertigung, wobei das mindestens eine teilweise angebrachte Partikel entweder ein teilweise geschmolzenes Partikel oder ein teilweise gesintertes Partikel ist; und
wobei das Bilden der Schicht aus reaktivem Material durch einen Gasphasenabscheidungsprozess erreicht wird und wobei der Gasphasenabscheidungsprozess Strömen von Gas, das das reaktive Material enthält, in einer laminaren Strömung beinhaltet.

2. Verfahren nach Anspruch 1, wobei das Bauteil ein inneres Merkmal beinhaltet und das innere Merkmal eine nicht in der Sichtlinie liegende Oberfläche (30) beinhaltet.

3. Verfahren nach Anspruch 2, wobei sich das mindestens eine teilweise angebrachte Partikel auf der nicht in Sichtlinie liegenden Oberfläche befindet.

4. Verfahren nach Anspruch 3, ferner umfassend Fördern einer Lösung durch die inneren Merkmale während des Auflösungsschritts, wobei die Lösung das reaktive Material auflöst.

5. Verfahren nach Anspruch 4, wobei die Lösung gegenüber dem Bauteil inert ist.

6. Verfahren nach einem der vorhergehenden Ansprüche, wobei das reaktive Material ein Element ist, ausgewählt aus Aluminium, Brom, Silizium, Chrom, Zink, Zinn, Titan, Yttrium oder einer Kombination davon, und wobei das reaktive Material vorzugsweise Aluminium ist und das Bauteil eine Nickellegierung umfasst.

7. Verfahren nach einem der vorhergehenden Ansprüche, ferner umfassend eine Wärmebehandlung des Bauteils, um die Diffusion des reaktiven Materials in eine Diffusionszone zu bewirken.

8. Verfahren nach Anspruch 7, wobei der Auflösungsschritt die Schicht aus reaktivem Material und die Diffusionszone auflöst.

9. Verfahren nach einem der vorhergehenden Ansprüche, wobei der Auflösungsschritt mit einer sauren Lösung erreicht wird, und wobei die saure Lösung vorzugsweise eine 20 %- bis 50 %ige Lösung von Salpetersäure ist, und wobei der Auflösungsschritt bei einer Temperatur zwischen etwa 32,2 und 37,8 °C (90 und 100 °F) durchgeführt wird.

## Revendications

1. Procédé de réduction de rugosité de surface d'un composant, comprenant :
la formation d'une couche (32) de matériau réactif sur une surface (28) d'un composant (20), la surface du composant ayant au moins une particule partiellement fixée (26), moyennant quoi le matériau réactif recouvre sensiblement l'au moins une particule partiellement fixée ; et
la dissolution du matériau réactif, dans lequel la dissolution du matériau réactif recouvrant les particules partiellement fixées amène les particules partiellement fixées à se libérer de la surface du composant, laissant une nouvelle surface lisse ; et **caractérisé par**
comprenant en outre la formation du composant par fabrication additive, et dans lequel l'au moins une particule partiellement fixée est l'une parmi une particule partiellement fondue et une particule partiellement frittée ; et
dans lequel la formation de la couche de matériau réactif est réalisée par un processus de dépôt en phase gazeuse, et dans lequel le processus de dépôt en phase gazeuse comporte l'écoulement d'un gaz contenant le matériau réactif dans un écoulement laminaire.

2. Procédé selon la revendication 1, dans lequel le composant comporte une caractéristique interne, et la caractéristique interne comporte une surface sans visibilité directe (30).

3. Procédé selon la revendication 2, dans lequel l'au moins une particule partiellement attachée se trouve sur la surface sans visibilité directe.

4. Procédé selon la revendication 3, comprenant en outre le transport d'une solution à travers les caractéristiques internes pendant l'étape de dissolution, la solution dissolvant le matériau réactif.

5. Procédé selon la revendication 4, dans lequel la solution est inerte vis-à-vis du composant.

6. Procédé selon une quelconque revendication précédente, dans lequel le matériau réactif est un élément choisi parmi l'un de l'aluminium, du brome, du silicium, du chrome, du zinc, de l'étain, du titane, de l'yttrium ou toute combinaison de ceuxci, et de préférence dans lequel le matériau réactif est l'aluminium et le composant comprend un alliage de nickel.

7. Procédé selon une quelconque revendication précédente, comprenant en outre le traitement thermique du composant pour provoquer la diffusion du matériau réactif dans une zone de diffusion.

8. Procédé selon la revendication 7, dans lequel l'étape de dissolution dissout la couche de matériau réactif et la zone de diffusion.

9. Procédé selon une quelconque revendication précédente, dans lequel l'étape de dissolution est réalisée avec une solution acide, et de préférence dans lequel la solution acide est une solution à 20 % à 50 % d'acide nitrique, et dans lequel l'étape de dissolution est exécutée à une température comprise entre environ 32,2 et 37,8 °C (90 et 100 °F).
